# EUROPEAN PATENT APPLICATION

(11) **EP 4 676 181 A1**
(43) Date of publication of application: **07.01.2026**
(21) Application number: 25166734.1
(22) Date of filing: 27.03.2025
(51) Int. Cl.: H10B 41/50, H01L 23/528, H10B 43/50, H01L 23/522

(54) **VERTICAL NON-VOLATILE MEMORY DEVICE**

(30) Priority: 02.07.2024 KR 20240087045
(71) Applicant: Samsung Electronics Co., Ltd., Suwon-si, Gyeonggi-do 16677 (KR)
(72) Inventor: KIM, Sanghun, 16677 Suwon-si (KR); KWAK, Wooahm, 16677 Suwon-si (KR); KIM, Minsu, 16677 Suwon-si (KR); PARK, Jiwon, 16677 Suwon-si (KR); BAEK, Jaehwan, 16677 Suwon-si (KR); SHIM, Hyunseo, 16677 Suwon-si (KR); OH, Minkyo, 16677 Suwon-si (KR); LEE, Eunhye, 16677 Suwon-si (KR); LEE, Jaechan, 16677 Suwon-si (KR); LEE, Jinhyeong, 16677 Suwon-si (KR)
(74) Representative: Marks & Clerk LLP

(57) **Abstract**

A vertical non-volatile memory device may include a gate stack including gate electrodes and interlayer insulating layers alternately stacked, gate spacers, and gate contact plugs spaced apart from each other in the gate stack. The gate contact plugs may include a first gate contact plug vertically contacting a first gate electrode among the gate electrodes and a second gate contact plug vertically contacting a second gate electrode among the gate electrodes. The gate contact plugs may include vertical plug portions extending in a vertical direction and protrusion plug portions that horizontally protrude from both sides of the vertical plug portions. The gate spacers that may be between the protrusion plug portions and the gate electrodes. The gate spacers may insulate the gate contact plugs from some of the gate electrodes.

## Description

### BACKGROUND

Inventive concepts relate to a non-volatile memory device, and more specifically, to a vertical non-volatile memory device.

In electronic systems requiring data storage, non-volatile memory devices capable of storing large amounts of data may be required. Accordingly, vertical non-volatile memory devices having three-dimensionally arranged memory cells instead of two-dimensionally arranged memory cells have been proposed. Vertical non-volatile memory devices having three-dimensionally arranged memory cells may have low connection reliability of gate contact plugs connected to gate electrodes.

### SUMMARY

Inventive concepts provide a vertical non-volatile memory device capable of improving the connection reliability of gate contact plugs connected to gate electrodes of memory cells arranged three-dimensionally.

According to an embodiment of the inventive concepts, a vertical non-volatile memory device may include a gate stack including a plurality of gate electrodes and a plurality of interlayer insulating layers alternately stacked; gate spacers; and a plurality of gate contact plugs spaced apart from each other in the gate stack. The plurality of gate contact plugs may include a first gate contact plug vertically contacting a first gate electrode among the plurality of gate electrodes and a second gate contact plug vertically contacting a second gate electrode among the plurality of gate electrodes. The gate contact plugs may include a plurality of vertical plug portions extending in a vertical direction and a plurality of protrusion plug portions that horizontally protrude from both sides of the plurality of vertical plug portions. The gate spacers may be between the plurality of protrusion plug portions and the plurality of gate electrodes. The gate spacers may insulate the plurality of gate contact plugs from some of the plurality of gate electrodes.

According to an embodiment of the inventive concepts, a vertical non-volatile memory device may include a gate stack including a plurality of gate electrodes and a plurality of interlayer insulating layers alternately stacked; gate spacers; and a plurality of gate contact plugs spaced apart from each other in the gate stack. The gate stack may define a first vertical hole over a first gate electrode among the plurality of gate electrodes and exposing the first gate electrode, first horizontal recessed holes extending horizontally from the first vertical hole, a second vertical hole over a second gate electrode among the plurality of gate electrodes and exposing the second gate electrode, and second horizontal recessed holes extending horizontally from the second vertical hole. The plurality of gate contact plugs may include a first gate contact plug and a second gate contact plug. The first gate contact plug may be in the first vertical hole and may vertically contact the first gate electrode among the gate electrodes. The first gate contact plug may be arranged on one side of first horizontal recessed holes. The second gate contact plug may be in the second vertical hole and may vertically contact the second gate electrode. The second gate contact plug may be arranged on one side of second horizontal recessed holes. A first plurality of the gate spacers may be in the first horizontal recessed holes and a second plurality of the gate spacers may be in the second horizontal recessed holes. The first plurality of gate spacers may insulate the first gate contact plug from the plurality of gate electrodes other than the first gate electrode. The second plurality of gate spacers may insulate the second gate contact plug from the plurality of gate electrodes other than the second gate electrode.

According to an embodiment of the inventive concepts, a vertical non-volatile memory device may include a memory cell array structure including a memory cell array; gate spacers; and an extension structure extending from one side of the memory cell array structure and connected to a plurality of gate electrodes of the memory cell array structure. The memory cell array structure and the extension structure may include a gate stack. The gate stack may include the plurality of gate electrodes and a plurality of interlayer insulating layers alternately stacked, and the extension structure may include a plurality of gate contact plugs spaced apart from each other in the gate stack. The plurality of gate contact plugs may include a first gate contact plug vertically contacting a first gate electrode among the plurality of gate electrodes and a second gate contact plug vertically contacting a second gate electrode among the plurality of gate electrodes. The plurality of gate contact plugs may include a plurality of vertical plug portions extending in a vertical direction and a plurality of protrusion plug portions that horizontally protrude from both sides of the plurality of vertical plug portions. The gate spacers may be between the plurality of protrusion plug portions and the plurality of gate electrodes. The gate spacers may insulate the plurality of gate contact plugs from some of the plurality of gate electrodes.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a block diagram of a vertical non-volatile memory device according to an embodiment;
FIG. 2 is a schematic perspective view of a vertical non-volatile memory device according to an embodiment;
FIG. 3 is an equivalent circuit diagram of a memory cell array (MCA) of a vertical non-volatile memory device according to an embodiment;
FIG. 4 is a schematic plan view of a vertical non-volatile memory device according to an embodiment;
FIG. 5 is a cross-sectional view to explain in detail important components of a vertical non-volatile memory device according to an embodiment;
FIG. 6 is an enlarged cross-sectional view of a region EN1 in FIG. 5;
FIG. 7 is an enlarged cross-sectional view of a region EN2 in FIG. 5;
FIG. 8 is an enlarged cross-sectional view of a region EN3 in FIG. 7;
FIG. 9 is an enlarged view to explain the gate contact structure of FIG. 7 and FIG. 8; and
FIGS. 10 to 17 are cross-sectional views illustrating a method of manufacturing a vertical non-volatile memory device according to one embodiment.

### DETAILED DESCRIPTION

Hereinafter, embodiments of inventive concepts will be described in detail with reference to the accompanying drawings. The same reference numerals are used for the same components in the drawings, and redundant descriptions thereof are omitted.

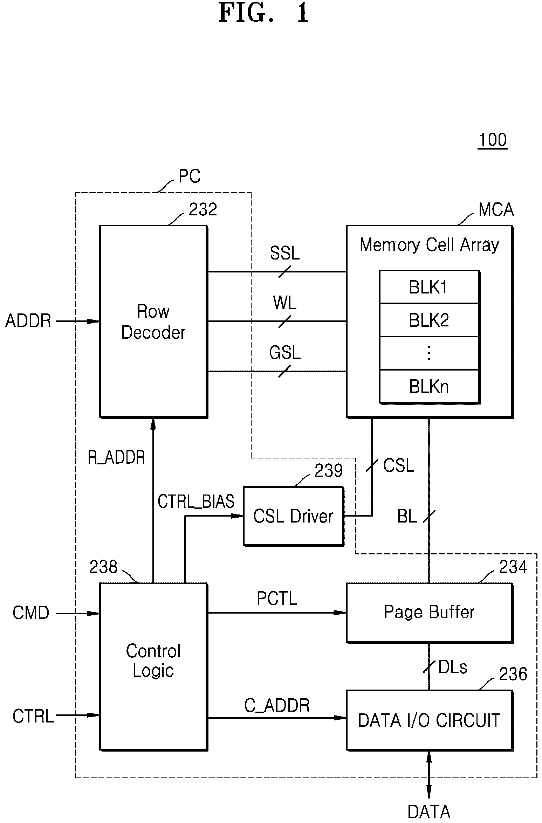

FIG. 1 is a block diagram of a vertical non-volatile memory device 100 according to an embodiment.

The vertical non-volatile memory device 100 may have a characteristic in which stored data may be continuously maintained even when power thereto is not supplied. The vertical non-volatile memory device 100 may be a vertical NAND flash memory device.

The vertical non-volatile memory device 100 may include a memory cell array MCA and a peripheral circuit PC. The memory cell array MCA may include a plurality of memory cell blocks BLK1, BLK2, ..., BLKn (where, n is a positive integer). The memory cell blocks BLK1, BLK2, ..., BLKn (where, n is a positive integer) may be collectively referred to as memory cell blocks BLK.

The memory cell blocks (BLK1, BLK2, ..., BLKn, where n is a positive integer) may each include a plurality of memory cells. The memory cell blocks BLK1, BLK2, ..., BLKn (where, n is a positive integer) may be connected to the peripheral circuit PC via a bit line BL, a word line WL, a string select line SSL, and a ground select line GSL.

The peripheral circuit PC may include a row decoder 232, a page buffer 234, a data input/output circuit 236, a control logic 238, and a common source line (CSL) driver 239. Although not shown in FIG. 1, the peripheral circuit PC may further include various circuits such as a voltage generation circuit that generates various voltages for the operation of the vertical non-volatile memory element 100, an error correction circuit for correcting errors in data read from the memory cell array MCA, and/or an input/output interface.

The memory cell array MCA may be connected to a page buffer 234 via the bit line BL. The memory cell array MCA may be connected to a row decoder 232 via a word line WL, a string select line SSL, and a ground select line GSL. In the memory cell array MCA, a plurality of memory cells included in each of a plurality of memory cell blocks BLK1, BLK2, ..., BLKn (where, n is a positive integer) may be flash memory cells.

The memory cell array MCA may include a three-dimensional memory cell array. The three-dimensional memory cell array may include a plurality of NAND strings. The plurality of NAND strings may include a plurality of memory cells connected to vertically stacked word lines WL, respectively.

The peripheral circuit PC may receive an address ADDR, a command CMD, and a control signal CTRL from the outside of the vertical non-volatile memory device 100 and may transmit and receive data DATA to and from a device located outside of the vertical non-volatile memory device 100.

The row decoder 232 may select at least one of the plurality of memory cell blocks BLK1, BLK2, ..., BLKn (where, n is a positive integer) in response to an address ADDR from the outside, and may select a word line WL, a string select line SSL, and a ground select line GSL of the selected memory cell block. The row decoder 232 may transmit a voltage for performing a memory operation to the word line WL of the selected memory cell block.

The page buffer 234 may be connected to the memory cell array MCA via a bit line BL. The page buffer 234 may act as a write driver during a program operation and may apply a voltage according to data DATA to be stored in the memory cell array MCA to the bit line BL and may operate as a sense amplifier during a read operation and detect data DATA stored in the memory cell array MCA. The page buffer 234 may operate according to a control signal PCTL provided from the control logic 238.

The data input/output circuit 236 may be connected to the page buffer 234 through a plurality of data lines DLs. The data input/output circuit 236 may receive data DATA from a memory controller (not shown) during a program operation and provide program data DATA to the page buffer 234 based on a column address C_ADDR provided from the control logic 238. The data input/output circuit 236 may provide read data DATA stored in the page buffer 234 to the memory controller based on a column address C_ADDR provided from the control logic 238 during a read operation.

The data input/output circuit 236 may transmit an input address or command to the control logic 238 and/or the row decoder 232. The peripheral circuit PC may further include an electrostatic discharge (ESD) circuit and/or a pull-up/pull-down driver.

The control logic 238 may receive a command CMD and a control signal CTRL from the memory controller. The control logic 238 may provide a row address R_ADDR to the row decoder 232 and a column address C_ADDR to the data input/output circuit 236. The control logic 238 may generate various internal control signals used in the vertical non-volatile memory device 100 in response to the control signal CTRL. For example, the control logic 238 may control a voltage level provided to the word line WL and the bit line BL when performing a memory operation, such as a program operation or an erase operation.

The CSL driver 239 may be connected to the memory cell array MCA through a common source line CSL. The CSL driver 239 may apply a common source voltage (e.g., a power supply voltage) or a ground voltage to the common source line CSL based on the control signal CTRL of the control logic 238. In example embodiments, the CSL driver 239 may be arranged below the memory cell array MCA. The CSL driver 239 may be arranged to vertically overlap at least a portion of the memory cell array MCA.

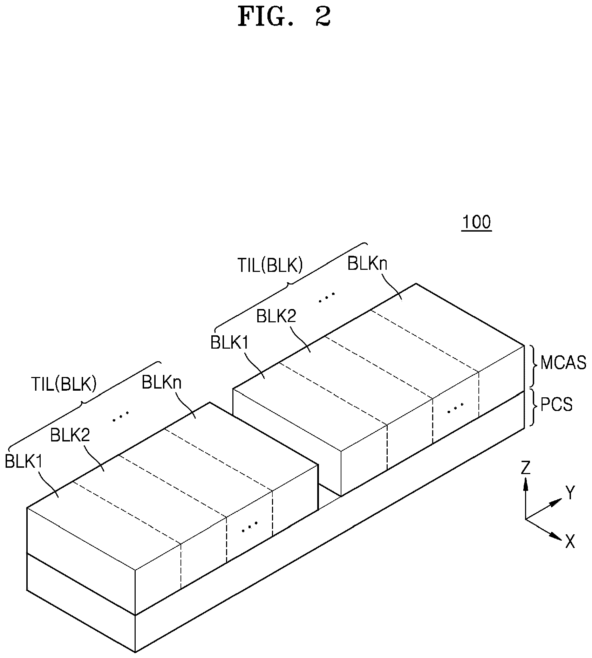

FIG. 2 is a schematic perspective view of a vertical non-volatile memory device according to an embodiment.

The vertical non-volatile memory device 100 may include a memory cell array structure MCAS and a peripheral circuit structure PCS that overlap each other in a vertical direction (Z direction). An X direction or -X direction may be referred to as a first horizontal direction. A Y direction or -Y direction may be referred to as a second horizontal direction.

In FIG. 2, the memory cell array structure MCAS is stacked vertically (in the Z direction) on the peripheral circuit structure PCS, but the peripheral circuit structure PCS may be arranged on one side of the memory cell array structure MCAS in the horizontal direction (in the X direction) as needed.

The memory cell array structure MCAS may include the memory cell array MCA of FIG. 1. The peripheral circuit structure PCS may include the peripheral circuit PC of FIG. 1. The memory cell array structure MCAS of FIG. 2 may include a plurality of tiles TIL. Each of the tiles TIL may include a plurality of memory cell blocks BLK1, BLK2, ..., BLKn (where, n is a positive integer). The memory cell blocks BLK1, BLK2, ..., BLKn (where, n is a positive integer) may be collectively referred to as memory cell blocks BLK. The memory cell blocks BLK1, BLK2, ..., BLKn (where, n is a positive integer) may include a plurality of memory cells arranged three-dimensionally.

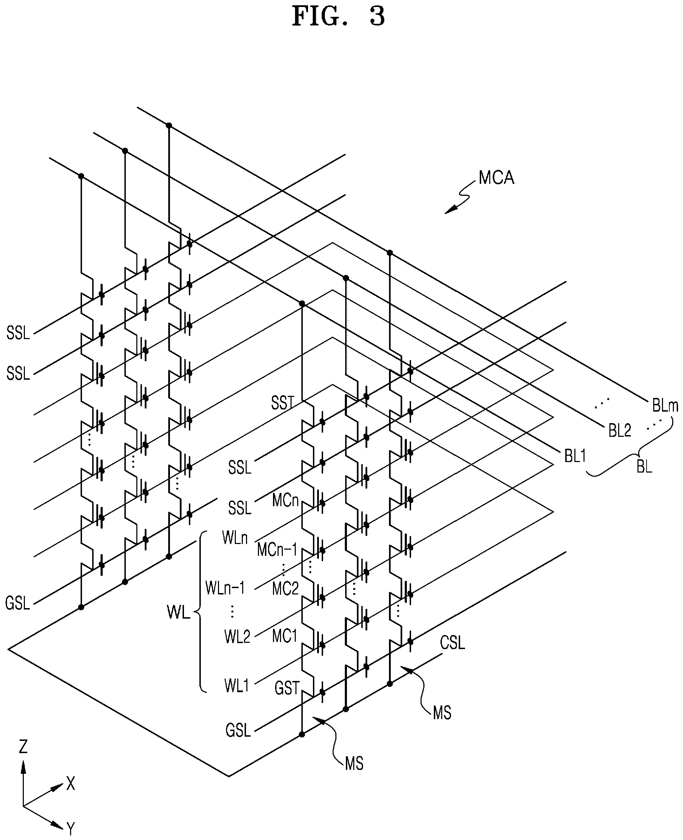

FIG. 3 is an equivalent circuit diagram of a memory cell array MCA of a vertical non-volatile memory device according to an embodiment.

FIG. 3 may be an equivalent circuit diagram of the memory cell array MCA of the vertical non-volatile memory device 100 described above with reference to FIG. 1, for example, a vertical NAND flash memory device. The memory cell blocks BLK1, BLK2, ..., BLKn (where, n is a positive integer) of FIG. 2 may each include a memory cell array MCA having a circuit configuration shown in FIG. 3.

The memory cell array MCA may include a plurality of memory cell strings MS. The memory cell array MCA may include a plurality of bit lines BL1, BL2, ..., BLm (where m is a positive integer), a plurality of word lines WL1, WL2, ..., WLn-1, WLn (where n is a positive integer), at least one string select line SSL, at least one ground select line GSL, and a common source line CSL.

A plurality of memory cell strings MS may be formed between the plurality of bit lines BL and the common source lines CSL. In FIG. 3, a case when each of the plurality of memory cell strings MS includes two string select lines SSL is shown, but the present embodiment is not limited thereto. For example, each of the plurality of memory cell strings MS may include one string select line SSL.

Each of the plurality of memory cell strings MS may include a string select transistor SST, a ground select transistor GST, and a plurality of memory cell transistors MC1, MC2, ..., MCn-1, MCn (where n is a positive integer). The memory cell transistors MC1, MC2, ..., MCn-1, MCn (where n is a positive integer) may respectively be memory cells.

A drain region of the string select transistor SST may be connected to the bit line BL, and a source region of the ground select transistor GST may be connected to the common source line CSL. The common source line CSL may be a region where the source regions of a plurality of ground select transistors GST are commonly connected.

The string select transistor SST may be connected to the string select line SSL, and the ground select transistor GST may be connected to the ground select line GSL. The plurality of memory cell transistors MC1, MC2, ..., MCn-1, MCn, (where n is a positive integer) may each be connected to a plurality of word lines WL.

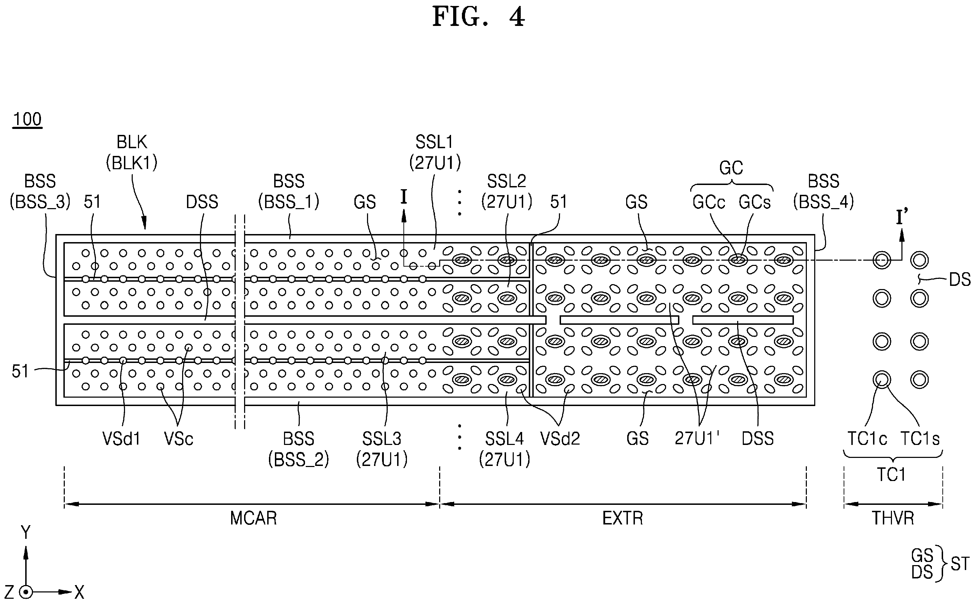

FIG. 4 is a schematic plan view of a vertical non-volatile memory device according to an embodiment.

The vertical non-volatile memory device 100 may include a plurality of memory cell blocks BLK, as described above with reference to FIGS. 1 and 2. FIG. 4 is a schematic plan view illustrating a first memory cell block BLK1 of one of the memory cell blocks BLK of the vertical non-volatile memory device 100 of FIGS. 1 and 2.

The plan view of the vertical non-volatile memory device 100 of FIG. 4 may be a plan view at a height level where the string select line SSL of FIG. 3 is located. The plan view of the first memory cell block BK1 illustrated in FIG. 4 is for explaining inventive concepts, and inventive concepts are not limited to FIG. 4.

Each of the memory cell blocks BLK may include a memory cell array region MCAR and an extension region EXTR arranged on at least one side of the memory cell array region MCAR. The extension region EXTR may be a region extending from the memory cell array region MACR in a first horizontal direction (X direction). The extension region EXTR may be referred to as a gate connection region. Each of the memory cell blocks BLK may have a line shape or a bar shape extending in a first horizontal direction (X direction).

The vertical non-volatile memory device 100 may include block separation structures BSS spaced apart from each other. The block separation structure BSS may include a shape of a closed loop surrounding each side of the memory cell blocks BLK.

The vertical non-volatile memory device 100 may include a stack structure ST. The stack structure ST may include a gate stack region GS and a dummy stack region DS. Each of the memory cell blocks BLK may include the gate stack region GS. The dummy stack region DS may be arranged on the outside of each of the memory cell blocks BLK. The dummy stack region DS may include a through contact region THVR.

Each of the memory cell blocks BLK may include vertical structures VSc, VSd1, and VSd2. The vertical structures VSc, VSd1, and VSd2 may include vertical memory structures VSc arranged in the memory cell array region MCAR, first vertical dummy structures VSd1 arranged in the memory cell array region MCAR, and second vertical dummy structures VSd2 arranged in the extension region EXTR.

Here, the vertical non-volatile memory device 100 is described in more detail with a focus on the first memory cell block BLK1 among the memory cell blocks BLK.

The first memory cell block BLK1 may be completely surrounded by the block separation structure BSS. The block separation structure BSS surrounding the first memory cell block BLK1 may include first and second line portions BSS_1 and BSS_2 that are parallel to each other and extend in the first horizontal direction (X direction), and third and fourth line portions BSS_3 and BSS_4 that are parallel to each other and extend in the second horizontal direction (Y direction). The block separation structure BSS surrounding the first memory cell block BLK1 may have a rectangular closed ring shape. The first memory cell block BLK1 may include string select lines SSL1, SSL2, SSL3, and SSL4.

The string select lines SSL1, SSL2, SSL3, and SSL4 of the memory cell array region MCAR may include a first upper gate electrode 27U1. In the extended region EXTR, a first dummy upper gate electrode 27U1' may be arranged to correspond to the first upper gate electrode 27U1 of the memory cell array region MCAR.

The vertical non-volatile memory device 100 may include auxiliary separation structures DSS. The auxiliary separation structures DSS may be arranged within the closed loop-shaped block separation structures BSS. The auxiliary separation structure DSS may include line portions that are spaced apart from each other and arranged in the first horizontal direction (X direction).

The auxiliary separation structure DSS may include a first line portion extending across the memory cell array region MCAR into the extension region EXTR, and second line portions spaced apart from the first line portion within the extension region EXTR and arranged sequentially in the first horizontal direction (X direction). The auxiliary separation structures DSS may separate the second and third string select lines SSL2 and SSL3.

The vertical non-volatile memory device 100 may include an upper separation pattern 51. The upper separation pattern 51 may be arranged between the first and second string select lines SSL1 and SSL2 and between the third and fourth string select lines SSL3 and SSL4. The upper separation pattern 51 may include a line portion extending in the first horizontal direction (X direction).

The vertical non-volatile memory device 100 may include a plurality of gate contact structures GC arranged within the first memory cell block BLK1. The gate contact structures GC may include gate contact plugs GCc and insulating gate spacers GCs.

The gate contact structures GC may be arranged to be spaced apart from each other within the gate stack region GS. The vertical non-volatile memory device 100 may include a plurality of through contact structures TC1 arranged within the through contact region THVR.

The gate contact structures GC may each include a gate contact plug GCc and a gate spacer GCs surrounding the gate contact plug GCc. The gate spacer GCs may include an insulating layer. The plurality of through contact structures TC1 may each include a through contact plug TC1c and an insulating spacer TC1s surrounding the through contact plug TC1c.

At least one of the gate contact structures GC may have an elongated bar shape or an oval shape in one direction, for example, the first horizontal direction (X direction). A width of each of the gate contact structures GC and the through contact structures TC1 may be greater than a width of each of the vertical memory structures VSc.

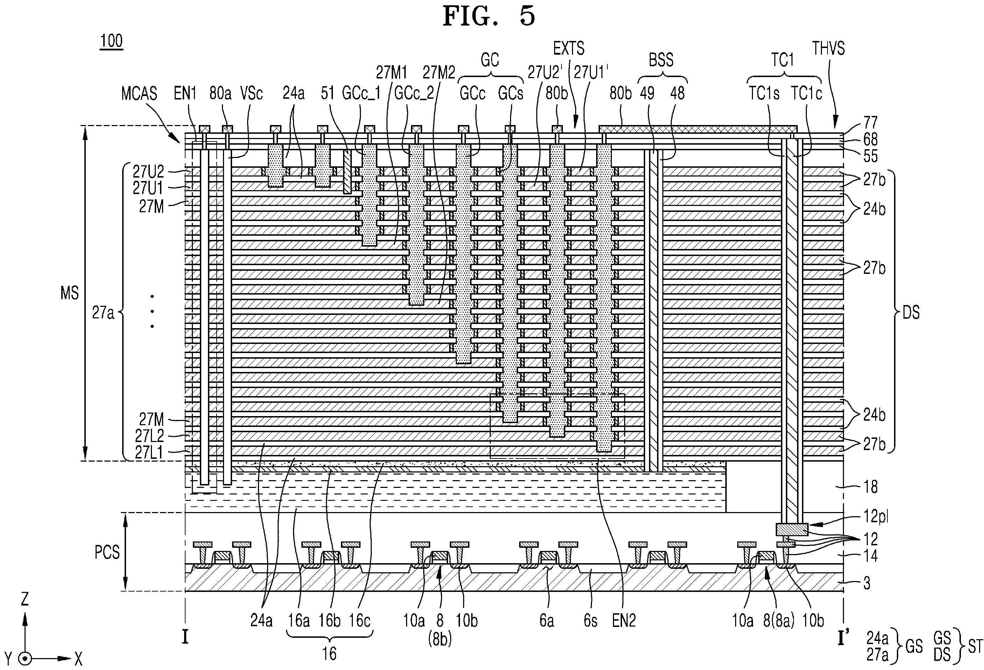

FIG. 5 is a cross-sectional view to explain in detail important components of the vertical non-volatile memory device according to an embodiment.

Specifically, FIG. 5 may be a cross-sectional view taken along line I-I' of FIG. 4. The vertical non-volatile memory device 100 may include a peripheral circuit structure PCS and an upper structure MS on the peripheral circuit structure PCS.

The peripheral circuit structure PCS may include a semiconductor substrate 3, device isolation regions 6s defining active regions 6a on the semiconductor substrate 3, peripheral circuits 8 on the active regions 6a, a circuit wiring 12 on the peripheral circuits 8 and electrically connected to the peripheral circuits 8, and an insulating structure 14 covering the peripheral circuits 8 and the circuit wiring 12. Each of the peripheral circuits 8 may include a transistor including a peripheral gate 10a and a peripheral source/drain 10b.

The peripheral circuits 8 may include a first peripheral circuit 8a and a second peripheral circuit 8b. The vertical non-volatile memory device 100 may include a plate pattern 16 and a dummy region 18 arranged on the peripheral circuit structure PCS. The dummy region 18 may be arranged on a side of the plate pattern 16. The dummy region 18 may include a dummy pattern, side surfaces of which are covered by an insulating material layer and/or an insulating material layer.

The plate pattern 16 may include a lower layer 16a, an intermediate layer 16b on the lower layer 16a, and an upper layer 16c on the intermediate layer 16b. The plate pattern 16 may include at least one silicon layer. For example, the lower layer 16a, the intermediate layer 16b, and the upper layer 16c may include a polysilicon layer having an N-type conductivity.

The upper structure MS may be arranged on the plate pattern 16 and the dummy region 18. The upper structure MS may include a memory cell array structure MCAS, an extension structure EXTS, and a through structure THVS. The memory cell array structure MCAS, the extension structure EXTS, and the through structure THVS may correspond to the memory cell array region MCAR, the extension region EXTR, and the through contact region THVR of FIG. 4, respectively.

The upper structure MS may include the stack structure ST, the separation structures including the block separation structures BSS and the auxiliary separation structures DSS, the vertical structures VSc, VSd1, and VSd2, the gate contact structures GC, and the through contact structures TC1 described with reference to FIG. 4. The upper structure MS may include first, second, and third upper insulating layers 55, 68, and 77, bit lines 80a, and gate connection wiring 80b.

The stack structure ST may include the gate stack region GS and the dummy stack region DS as described with reference to FIG. 4. The stack structure ST may include first layers 24a and 24b and second layers 27a and 27b that are alternately and repeatedly stacked. The second layers 27a and 27b may be stacked while spaced apart from each other in the vertical direction (Z) perpendicular to an upper surface of the plate pattern 16.

The first layers 24a and 24b may include an insulating material such as silicon oxide. The second layers 27a and 27b may include at least one of doped polysilicon, W, Ru, Mo, Ni, NiSi, Co, CoSi, Ti, TiN, and WN.

Among the first layers 24a and 24b, the first layers located within the gate stack region GS may be referred to as first interlayer insulating layers 24a, and the first layers located within the dummy stack region DS may be referred to as second interlayer insulating layers 24b. Among the second layers 27a and 27b, the second layers located within the gate stack region GS may be referred to as gate electrodes 27a, and the second layers located within the dummy stack region DS may be referred to as dummy gate electrodes 27b.

Accordingly, the gate stack region GS may include the first interlayer insulating layers 24a and the gate electrodes 27a that are alternately and repeatedly stacked. The gate stack region GS may have a structure in which the gate electrodes 27a and the first interlayer insulating layers 24a are alternately stacked.

The dummy stack region DS may include the second interlayer insulating layers 24b and the dummy gate electrodes 27b that are alternately and repeatedly stacked. The dummy stack region DS may have a structure in which the dummy gate electrodes 27b and the second interlayer insulating layers 24b are alternately stacked.

The separation structures BSS and DSS may penetrate the stack structure ST. Upper surfaces of the separation structures BSS and DSS may be arranged at a lower level than upper surfaces of the gate contact structures GC. The separation structures BSS and DSS may each include a core pattern 49 and an insulating spacer 48 disposed on a side of the core pattern 49. In one example, the core pattern 49 may include a conductive material and may be in contact with the lower layer 16a of the plate pattern 16. In another example, the core pattern 49 may include an insulating material.

The vertical structures VSc, VSd1, and VSd2 may penetrate the gate stack region GS. The first upper insulating layer 55, the second upper insulating layer 68, and the third upper insulating layer 77 are sequentially stacked on the stack structure ST.

The gate contact structures GC may extend downward through the first upper insulating layer 55. As described above, the gate contact structure GC may include the gate contact plug GCc and the gate spacer GCs. The gate spacer GCs may include an insulating material. For example, the gate spacer GCs may include at least one of silicon oxide, silicon nitride, silicon oxynitride, or a low-k dielectric (relative to silicon oxide).

The gate contact plugs GCc may have bottom surfaces at different levels and may have top surfaces at the same level. The gate contact plugs GCc may contact the gate electrodes 27a in the vertical direction (Z direction).

The gate contact plugs GCc may include a first gate contact plug that is in vertical contact with a first gate electrode (one of 27L1, 27L2, 27M, 27U1, and 27U2) among the gate electrodes 27a, and a second gate contact plug that is in vertical contact with a second gate electrode (one of 27L1, 27L2, 27M, 27U1, and 27U2) among the gate electrodes 27a.

The second gate electrode (one of 27L1, 27L2, 27M, 27U1, and 27U2), for example, the intermediate gate electrodes 27M, may be at a higher level than the first gate electrode (one of 27L1, 27L2, 27M, 27U1, and 27U2), for example, the second lower gate electrode 27L2 within the gate stack region GS. The gate contact plugs GCc may be electrically connected to the gate electrodes 27a.

The gate electrodes 27a may include a first intermediate gate electrode 27M1 and a second intermediate gate electrode 27M2 at a lower level than the first intermediate gate electrode 27M1. The gate electrodes 27a may include a first lower gate electrode 27L1, a second lower gate electrode 27L2, a plurality of intermediate gate electrodes 27M, a first upper gate electrode 27U1, and a second upper gate electrode 27U2 that are sequentially stacked in the vertical direction (Z direction).

In the extended region EXTR, first and second dummy upper gate electrodes 27U1' and 27U2' may be arranged to correspond to the first and second upper gate electrodes 27U1 and 27U2 of the memory cell array region MCAR, respectively.

The gate contact plugs GCc may include a first intermediate gate contact plug GCc_1 that contacts the first intermediate gate electrode 27M1 and a second intermediate gate contact plug GCc_2 that contacts the second intermediate gate electrode 27M2 at a level lower than the first intermediate gate electrode 27M1. The first and second intermediate gate electrodes 27M1 and 27M2 may be first and second word lines.

In one example, if the first intermediate gate contact plug GCc_1 and the second intermediate gate contact plug GCc_2 are arranged adjacent to each other in the first horizontal direction (X direction) and sequentially arranged, one or more gate electrodes may be located between the first intermediate gate electrode 27M1 and the second intermediate gate electrode 27M2.

The through contact structures TC1 penetrate the first and second upper insulating layers 55 and 68, the dummy stack region DS, and the dummy region 18. The through contact structure TC1 may extend downward and be electrically connected to the first peripheral circuit 8a among the peripheral circuits 8. For example, the through contact structures TC1 may include through contact plugs TC1c and insulating spacers TC1s surrounding the through contact plugs TC1c. The through contact plugs TC1c may be electrically connected to and in contact with first peripheral pads 12p1 of the circuit wiring 12 that are electrically connected to the first peripheral circuit 8a.

The bit lines 80a may be electrically connected to the vertical memory structures VSc. For example, the bit lines 80a may include line portions on the third upper insulating layer 77 and via portions penetrating the first to third upper insulating layers 55, 68, and 77 below the line portions and contacting the vertical memory structures VSc.

The gate connection wiring 80b may electrically connect the gate contact plugs GCc and the through contact plugs TC1c. For example, the gate connection wiring 80b may include line portions on the third upper insulating layer 77 and via portions that penetrate the second and third upper insulating layers 68 and 77 below the line portions and contact the through contact plugs TC1c and the gate contact plugs GCc.

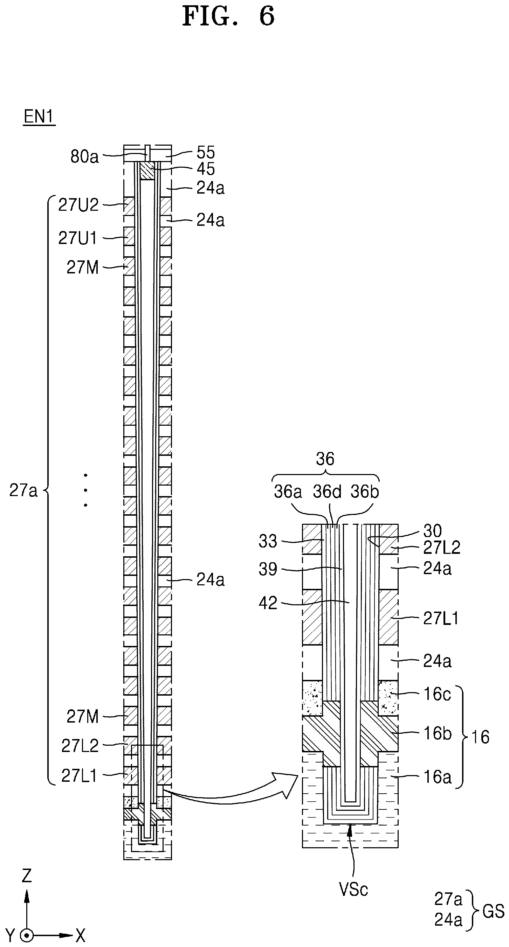

FIG. 6 is an enlarged cross-sectional view of the region EN1 in FIG. 5.

Specifically, the gate electrodes 27a may include the first lower gate electrode 27L1, the second lower gate electrode 27L2, the plurality of intermediate gate electrodes 27M, the first upper gate electrode 27U1, and the second upper gate electrode 27U2 that are sequentially stacked in the vertical direction (Z direction) as described above.

In one example, the first lower gate electrode 27L1 and the second lower gate electrode 27L2 may be lower select gate lines. The first and second lower select gate lines may be ground select gate lines. The intermediate gate electrodes 27M may be word lines WL. The first upper gate electrode 27U1 and the second upper gate electrode 27U2 may be upper select gate lines. The upper select gate lines may be string select gate lines.

The vertical memory structures VSc of FIG. 6 are illustrative, and the present embodiment is not limited to the structure of FIG. 6. The vertical memory structures VSc may each include a channel hole 30, an insulating core region 42, a pad pattern 45 on the insulating core region 42, an information storage structure 36 on a side of the insulating core region 42 and a side of the pad pattern 45, and a channel layer 39 between the insulating core region 42 and the information storage structure 36 and between the pad pattern 45 and the information storage structure 36.

The vertical memory structures VSc may include a block dielectric layer 33 covering an outer side and a bottom surface of the information storage structure 36. The pad pattern 45 may include doped silicon, for example, polysilicon having an N-type conductivity. The channel layer 39 may be in contact with the pad pattern 45. The channel layer 39 may include a silicon layer.

The information storage structure 36 may include a first dielectric layer 36a, an information storage layer 36d, and a second dielectric layer 36b. The information storage layer 36d may be between the first dielectric layer 36a and the second dielectric layer 36b. The first dielectric layer 36a may include silicon oxide and/or a high-k dielectric (relative to silicon oxide).

The information storage layer 36d may include a material capable of storing information in a NAND flash memory device, for example, silicon nitride capable of trapping charge. The second dielectric layer 36b may be a tunnel dielectric layer that contacts the channel layer 39.

The second dielectric layer 36b may include silicon oxide or silicon oxide doped with an impurity. The block dielectric layer 33 may include silicon oxide and/or a high-k dielectric. Among the plate patterns 16, an intermediate layer 16b may penetrate the block dielectric layer 33 and the information storage structure 36 and may be in contact with the channel layer 39. The intermediate layer 16b may include a silicon layer having an N-type conductivity, and a portion of the channel layer 39 in contact with the intermediate layer 16b may have an N-type conductivity.

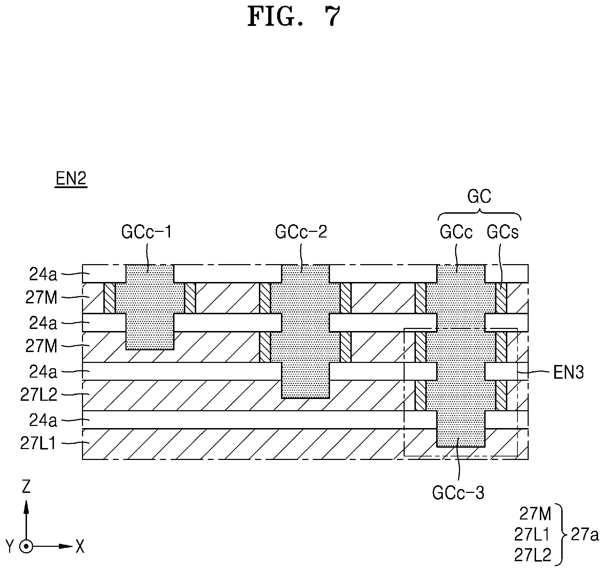

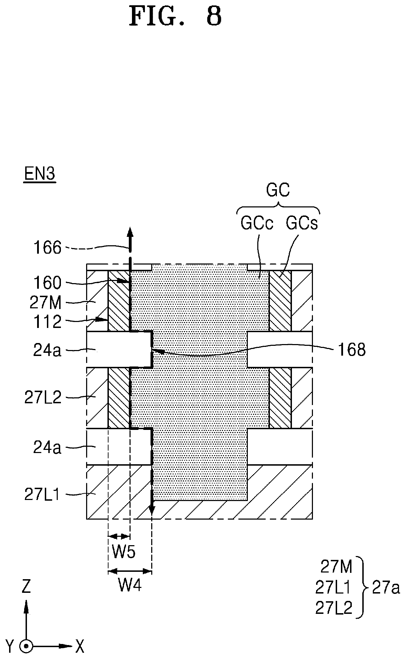

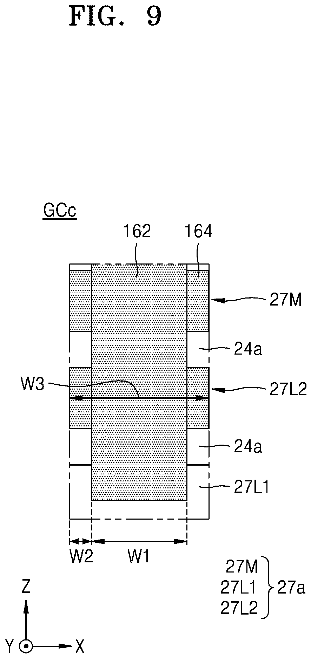

FIG. 7 is an enlarged cross-sectional view of a region EN2 in FIG. 5, FIG. 8 is an enlarged cross-sectional view of a region EN3 in FIG. 7, and FIG. 9 is an enlarged view illustrating the gate contact structure of FIGS. 7 and 8.

Specifically, the gate contact structures GC may include the gate contact plugs GCc and the gate spacers GCs as described above. The gate contact plugs GCc may include tungsten, titanium, tantalum, copper, aluminum, titanium nitride, tantalum nitride, tungsten nitride, or any combination thereof.

The gate contact plugs GCc, as illustrated in FIGS. 8 and 9, may include vertical plug portions 162 extending in the vertical direction (Z direction) and protrusion plug portions 164 protruding in the first horizontal direction (X direction and -X direction) on both sides of the vertical plug portions 162. The protrusion plug portions 164 may extend in the horizontal direction (X direction) and may be referred to as horizontal plug portions.

Bottom portions of the vertical plug portions 162 may be in contact with upper portions of the gate electrodes 27a. The protrusion plug portions 164 do not contact the gate electrodes 27a by the gate spacers GCs.

The vertical plug portions 162 may have a different width from the protrusion plug portions 164 in the first horizontal direction (X direction). The vertical plug portions 162 may have a first width W1 in the first horizontal direction (X direction). The protrusion plug portions 164 may have a second width W2 in the first horizontal direction (X direction). The second width W2 in each of protrusion plug portions 164 may be less than the first width W1.

The gate contact plugs GCc may have different widths in the first horizontal direction (X direction) at a level of the gate electrodes 27a and a level of the first interlayer insulating layers 24a. The gate contact plugs GCc have a third width W3 at the level of the gate electrodes 27a excluding the first lower gate electrode 27L1.

The gate contact plugs GCc have the first width W1 at a level of the first interlayer insulating layers 24a. The third width W3 may be greater than the first width W1. The gate contact plugs GCc may have a surface 166, side walls of which are curved in the vertical direction (Z direction) or have bent surfaces, as illustrated in FIG. 8.

The gate spacers GCs may be arranged between the protrusion plug portions 164 and the gate electrodes 27a to insulate the gate contact plugs GCc from the gate electrodes 27a. The gate spacers GCs may be partially embedded in horizontal recessed holes 112 recessed in the first horizontal direction (X direction or -X direction) from one sidewall 168 of the first interlayer insulating layers 24a between levels of the first interlayer insulating layers 24a. The horizontal recessed holes 112 may have a fourth width W4 in the first horizontal direction (X direction).

The gate spacers GCs may be formed by being recessed inward from the one sidewall 168 of the first interlayer insulating layers 24a. The gate spacers GCs may have a fifth width W5 in the first horizontal direction (X direction). The fifth width W5 may be less than the fourth width W4.

An extended region (or gate connection region) of the vertical non-volatile memory device 100 according to an embodiment includes the gate stacking region GS having a structure in which the gate electrodes 27a and the first interlayer insulating layers 24a are alternately stacked. The gate contact plugs GCc are arranged within the gate stack region GS.

The gate contact plugs GCc include a plurality of vertical plug portions 162 extending in the vertical direction and a plurality of protrusion plug portions 164 protruding in the horizontal direction from both sides of the vertical plug portions 162. The gate spacers GCs that insulate the gate contact plugs GCc and the gate electrodes 27a are arranged between the protrusion plug portions 164 and the gate electrodes 27a. The vertical non-volatile memory device 100 having such a configuration may improve the connection reliability between the gate electrodes 27a of the memory cells three-dimensionally arranged and the gate contact plugs GCc.

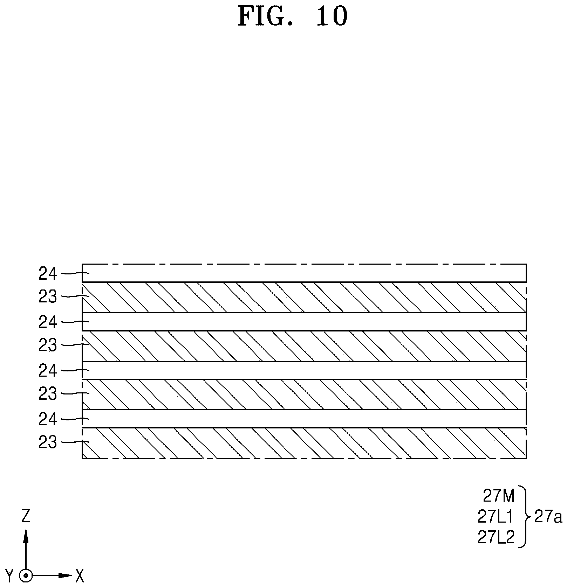

FIGS. 10 to 17 are cross-sectional views to explain a manufacturing method of a vertical non-volatile memory device according to an embodiment.

Specifically, FIGS. 10 to 17 are cross-sectional views to explain a manufacturing method for manufacturing the EN2 of FIG. 7. In FIGS. 10 to 17, like reference numerals as in FIGS. 7 to 9 represent like members. In FIGS. 10 to 17, descriptions as those given with reference to FIGS. 7 to 9 are briefly given or omitted.

Referring to FIG. 10, a plurality of sacrificial material layers 23 and a plurality of interlayer insulating material layers 24 are alternately stacked one layer at a time on the plate pattern 16 (refer to FIG. 5). The sacrificial material layers 23 may include silicon nitride, silicon carbide, or polysilicon.

The sacrificial material layers 23 may secure a space for forming a gate line (or gate electrode) in a subsequent process. The interlayer insulating material layers 24 may include silicon oxide.

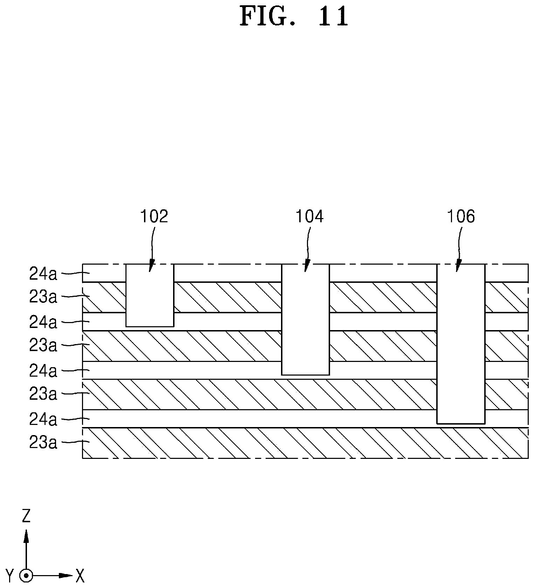

Referring to FIG. 11, the interlayer insulating material layers 24 (refer to FIG. 10) and the sacrificial material layers 23 (refer to FIG. 10) are patterned to form first to third vertical holes 102, 104, and 106. The first to third vertical holes 102, 104, and 106 may be formed by etching the interlayer insulating material layers 24 (refer to FIG. 10) and the sacrificial material layers 23 (refer to FIG. 10) using a photolithography process. For example, the first to third vertical holes 102, 104, and 106 may be formed by etching the interlayer insulating material layers 24 (refer to FIG. 10) and the sacrificial material layers 23 (refer to FIG. 10) using a wet etching process.

The first to third vertical holes 102, 104, and 106 may be formed to be spaced apart from each other in the first horizontal direction (X direction). Depths of the first to third vertical holes 102, 104, and 106 may be different from each other. According to the formation of the first to third vertical holes 102, 104, and 106, the interlayer insulating material layers 24 (refer to FIG. 10) and the sacrificial material layers 23 (refer to FIG. 10) may form the interlayer insulating layers 24a and the sacrificial layers 23a, respectively.

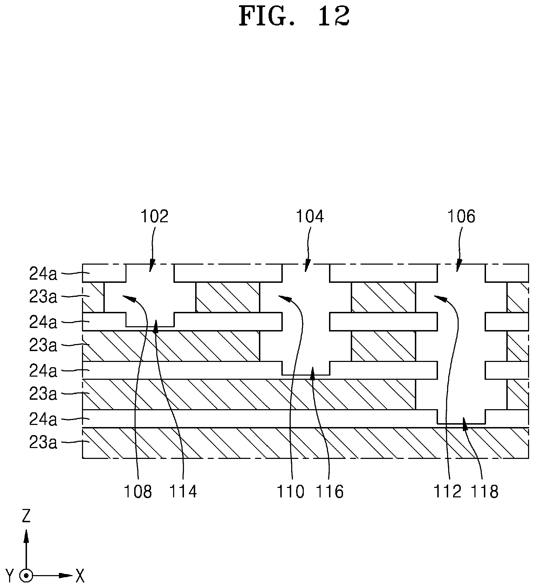

Referring to FIG. 12, the sacrificial layers 23a are selectively etched in the first horizontal direction (X direction and -X direction) within the first to third vertical holes 102, 104, and 106. Accordingly, first to third horizontal recessed holes 108, 110, and 112 recessed in the first horizontal direction (X direction and -X direction) are formed within the first to third vertical holes 102, 104, and 106, respectively.

For example, the first to third horizontal recessed holes 108, 110, and 112 may be formed by wet etching the sacrificial layers 23a. The first to third horizontal recessed holes 108, 110, and 112 may be formed by etching using the etching selectivity between the sacrificial layers 23a and the interlayer insulating layers 24a. When wet etching the sacrificial layers 23a, first to third bottom portions 114, 116, and 118 of the first to third vertical holes 102, 104, and 106 may be hardly etched.

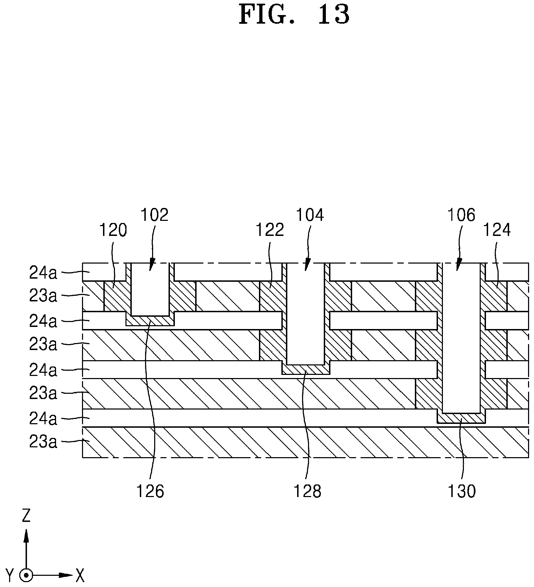

Referring to FIG. 13, first to third buried insulating layers 120, 122, and 124 that are buried in the first to third horizontal recessed holes 108, 110, 112, respectively, are formed in the first to third vertical holes 102, 104, and 106.

Also, first to third bottom insulating layers 126, 128, and 130 are respectively formed on the first to third bottom portions 114, 116, and 118 of the first to third vertical holes 102, 104, and 106. When the first to third buried insulating layers 120, 122, and 124 and the first to third bottom insulating layers 126, 128, and 130 are formed, an insulating layer may also be formed on sidewalls of the interlayer insulating layers 24a within the first to third vertical holes 102, 104, and 106. The first to third buried insulating layers 120, 122, and 124 and the first to third bottom insulating layers 126, 128, and 130 may include aluminum oxide.

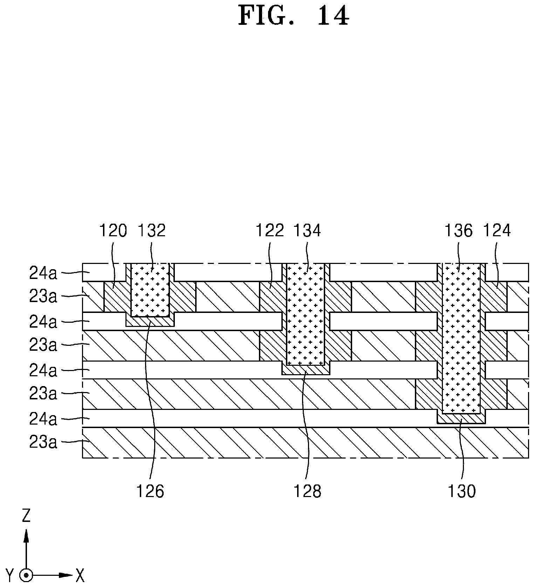

Referring to FIG. 14, first to third buried sacrificial layers 132, 134, and 136 that fill the inside of the first to third vertical holes 102, 104, and 106 (refer to FIG. 13) are formed on the first to third buried insulating layers 120, 122, and 124 and the first to third bottom insulating layers 126, 128, and 130. The first to third buried sacrificial layers 132, 134, and 136 may include silicon nitride, polysilicon, or silicon carbide.

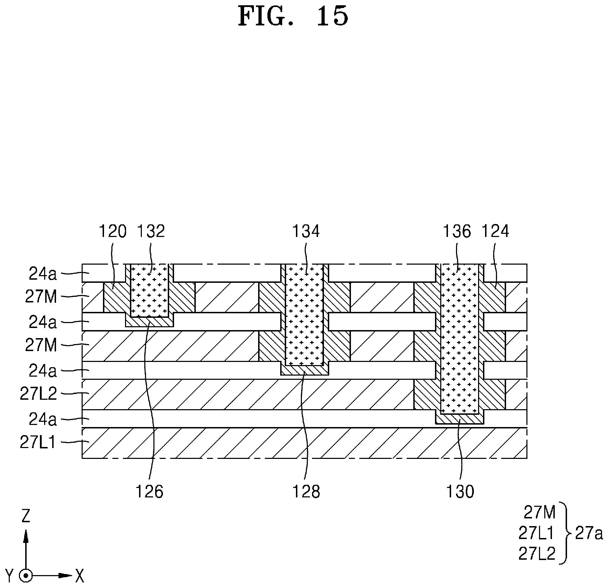

Referring to FIG. 15, the sacrificial layers 23a (refer to FIG. 14) are replaced with gate electrodes 27a. After the sacrificial layers 23a (refer to FIG. 14) are etched and removed, the gate electrodes 27a are formed in the removed space.

In FIG. 15, the gate electrodes 27a may include a first lower gate electrode 27L1, a second lower gate electrode 27L2, and an intermediate gate electrode 27M that are sequentially stacked in the vertical direction (Z direction).

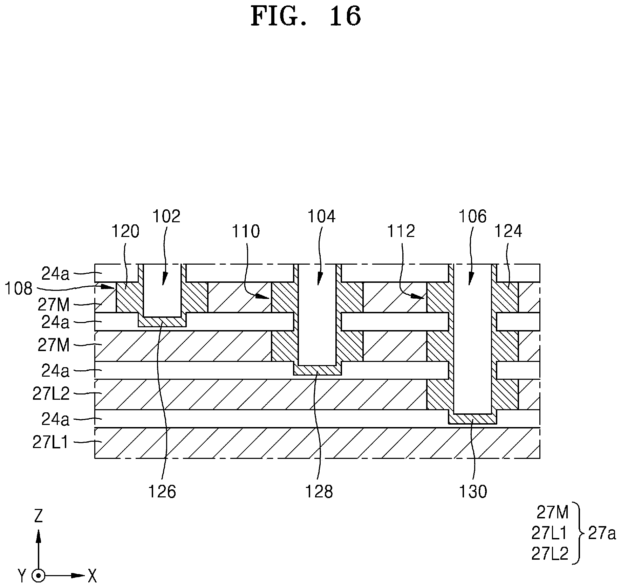

Referring to FIG. 16, the first to third buried sacrificial layers 132, 134, and 136 (refer to FIG. 15) are removed. The first to third buried sacrificial layers 132, 134, and 136 (refer to FIG. 15) are removed by using a wet etching method.

As a result, the end result is that the first to third bottom insulating layers 126, 128, and 130 are respectively formed in the first to third vertical holes 102, 104, and 106, and the first to third buried insulating layers 120, 122, and 124 are respectively formed in the first to third horizontal recessed holes 108, 110, and 112.

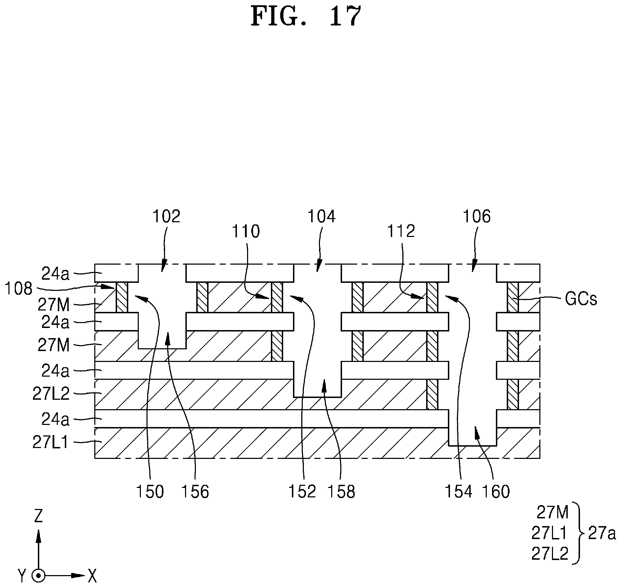

Referring to FIG. 17, the first to third buried insulating layers 120, 122, and 124 (refer to FIG. 16), the first to third bottom insulating layers 126, 128, and 130 (refer to FIG. 16), and the interlayer insulating layers 24a under the first to third bottom insulating layers 126, 128, and 130 (refer to FIG. 16) are etched by wet etching.

In this way, the first to third buried insulating layers 120, 122, and 124 (refer to FIG. 16) may be etched within the first to third horizontal recessed holes 108, 110, and 112 to form gate spacers GCs. The first to third buried insulating layers 120, 122, and 124 (refer to FIG. 16) may be recess-etched on one sidewall of the interlayer insulating layers 24a as shown by reference numerals 150, 152, and 154 to form the gate spacers GCs.

In addition, if the first to third bottom insulating layers 126, 128, and 130 (refer to FIG. 16) and the interlayer insulating layers 24a under the first to third bottom insulating layers 126, 128, and 130 (refer to FIG. 16) are etched using a wet etching method, the first to third vertical holes 102, 104, and 106 may easily expose the gate electrodes 27a, respectively. Bottom portions 156, 158, and 160 of the first to third vertical holes 102, 104, and 106 may be portions that expose the gate electrodes 27a.

Continuing, as illustrated in FIG. 7, gate contact plugs GCc are formed in the first to third vertical holes 102, 104, and 106 that expose the gate electrodes 27a, thereby forming a gate contact structure GC.

The gate contact plugs GCc formed in the first to third vertical holes 102, 104, and 106 that expose the gate electrodes 27a may be easily connected to the gate electrodes 27a. In other words, the connection reliability between the gate contact plugs GCc and the gate electrodes 27a in the first to third vertical holes 102, 104, and 106 that expose the gate electrodes 27a may be improved.

Here, the gate contact structure GC is described with reference to FIG. 7.

As illustrated in FIG. 7, the gate contact plugs GCc may include a first gate contact plug GCc-1 buried in the first vertical hole 102 that is in vertical contact with the first gate electrode 27M among the gate electrodes 27a and arranged on one side of the first horizontal recessed holes 108 that extend horizontally from the first vertical hole 102.

The gate contact plugs GCc may include a second gate contact plug GCc-2 filled in the second vertical hole 104 that is in vertical contact with the second gate electrode 27L2 among the gate electrodes 27a and arranged on one side of second horizontal recessed holes 110 that extend horizontally from the second vertical hole 104. The first gate electrode 27M may be at a higher level than the second gate electrode 27L2 within the gate stack region GS (refer to FIG. 5).

The gate contact plugs GCc may include a third gate contact plug GCc-3 buried in the third vertical hole 106 that is in vertical contact with the third gate electrode 27L1 among the gate electrodes 27a and arranged on one side of the third horizontal recess holes 112 that extend horizontally from the third vertical hole 106. The second gate electrode 27L2 may be at a higher level than the third gate electrode 27L1 within the gate stack region GS (refer to FIG. 5).

The gate spacers GCs may be partially buried in the first horizontal recessed holes 108, the second horizontal recessed holes 110, and the third horizontal recessed holes 112 to insulate the gate contact plugs GCc and the gate electrodes 27a.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While inventive concepts have been described in detail with reference to embodiments, inventive concepts are not limited thereto, and various modifications and changes may be made by those skilled in the art within the technical information and scope of inventive concepts.

## Claims

1. A vertical non-volatile memory device comprising:
a gate stack including a plurality of gate electrodes and a plurality of interlayer insulating layers alternately stacked;
gate spacers; and
a plurality of gate contact plugs spaced apart from each other in the gate stack,
wherein the plurality of gate contact plugs include a first gate contact plug vertically contacting a first gate electrode among the plurality of gate electrodes and a second gate contact plug vertically contacting a second gate electrode among the plurality of gate electrodes,
wherein the gate contact plugs include a plurality of vertical plug portions extending in a vertical direction and a plurality of protrusion plug portions that horizontally protrude from both sides of the plurality of vertical plug portions, and
wherein the gate spacers are between the plurality of protrusion plug portions and the plurality of gate electrodes, and the gate spacers insulate the plurality of gate contact plugs from some of the plurality of gate electrodes.

2. The vertical non-volatile memory device of claim 1, wherein bottom portions of the plurality of vertical plug portions are in contact with upper portions of the plurality of gate electrodes.

3. The vertical non-volatile memory device of claim 1 or claim 2, wherein a level of the first gate electrode is higher than a level of the second gate electrode in the gate stack.

4. The vertical non-volatile memory device of any preceding claim, wherein widths of the plurality of vertical plug portions are different from widths from the protrusion plug portions in a horizontal direction, and
wherein the plurality of vertical plug portions have a first width in the horizontal direction, the plurality of protrusion plug portions have a second width in the horizontal direction, and the second width in each of protrusion plug portions is less than the first width.

5. The vertical non-volatile memory device of any preceding claim, wherein a corresponding one of the plurality of the gate contact plugs has different widths in a horizontal direction at a level of a corresponding one of the plurality of gate electrodes and a level of a corresponding one of the plurality of interlayer insulating layers.

6. The vertical non-volatile memory device of any preceding claim, wherein sidewalls of the plurality of gate contact plugs have bent surfaces.

7. The vertical non-volatile memory device of any preceding claim, wherein the plurality of gate electrodes include horizontal recessed holes that are recessed in a horizontal direction from sidewalls of one side of the plurality of interlayer insulating layers, and the gate spacers are in the horizontal recessed holes, and
wherein widths of the gate spacers in the horizontal direction are less than widths that the horizontally recessed holes are recessed in the horizontal direction from the sidewalls of the one side of the plurality of interlayer insulating layers.

8. A vertical non-volatile memory device comprising:
a gate stack including a plurality of gate electrodes and a plurality of interlayer insulating layers alternately stacked;
gate spacers; and
a plurality of gate contact plugs spaced apart from each other in the gate stack,
wherein the gate stack defines a first vertical hole over a first gate electrode among the plurality of gate electrodes and exposing the first gate electrode, first horizontal recessed holes extending horizontally from the first vertical hole, a second vertical hole over a second gate electrode among the plurality of gate electrodes and exposing the second gate electrode, and second horizontal recessed holes extending horizontally from the second vertical hole,
wherein the plurality of gate contact plugs include a first gate contact plug and a second gate contact plug,
the first gate contact plug is in the first vertical hole and vertically contacting the first gate electrode among the gate electrodes,
the first gate contact plug is arranged on one side of first horizontal recessed holes,
the second gate contact plug is in the second vertical hole and vertically contacts the second gate electrode,
the second gate contact plug is arranged on one side of second horizontal recessed holes, and
wherein a first plurality of the gate spacers are in the first horizontal recessed holes and a second plurality of the gate spacers are in the second horizontal recessed holes, the first plurality of gate spacers insulate the first gate contact plug from the plurality of gate electrodes other than the first gate electrode, and the second plurality of gate spacers insulate the second gate contact plug from the plurality of gate electrodes other than the second gate electrode.

9. The vertical non-volatile memory device of claim 8, wherein a level of the first gate electrode in the gate stack is higher than a level of the second gate electrode in the gate stack.

10. The vertical non-volatile memory device of claim 8 or claim 9, wherein the plurality of gate contact plugs include vertical plug portions and horizontal plug portions, the vertical plug portions of the first gate contact plug are in the first vertical hole, the vertical plug portions of the second gate contact plug are in the second vertical hole, the horizontal plug portions of the first gate contact plug are in the first horizontal recessed holes, and the horizontal plug portions of the second gate contact plug are in the second horizontal recessed holes, and
wherein in a horizontal direction, the vertical plug portions of the plurality of gate contact plugs are wider than the horizontal plug portions of the plurality of gate contact plugs.

11. The vertical non-volatile memory device of any of claims 8-10, wherein
in a horizontal direction, widths of the plurality of gate contact plugs at levels of the plurality of gate electrodes are greater than widths of the plurality of gate contact plugs at levels of the plurality of interlayer insulating layers.

12. The vertical non-volatile memory device of any of claims 8-11, wherein sidewalls of the plurality of gate contact plugs have curved surfaces.

13. A vertical non-volatile memory device comprising:
a memory cell array structure including a memory cell array;
gate spacers; and
an extension structure extending from one side of the memory cell array structure and connected to a plurality of gate electrodes of the memory cell array structure,
wherein the memory cell array structure and the extension structure include a gate stack,
wherein the gate stack includes the plurality of gate electrodes and a plurality of interlayer insulating layers alternately stacked, and
the extension structure includes a plurality of gate contact plugs spaced apart from each other in the gate stack,
wherein the plurality of gate contact plugs include a first gate contact plug vertically contacting a first gate electrode among the plurality of gate electrodes and a second gate contact plug vertically contacting a second gate electrode among the plurality of gate electrodes, and
wherein the plurality of gate contact plugs include a plurality of vertical plug portions extending in a vertical direction and a plurality of protrusion plug portions that horizontally protrude from both sides of the plurality of vertical plug portions, and
wherein the gate spacers are between the plurality of protrusion plug portions and the plurality of gate electrodes, and the gate spacers insulate the plurality of gate contact plugs from some of the plurality of gate electrodes.

14. The vertical non-volatile memory device of claim 13, wherein
bottom portions of the plurality of vertical plug portions are in contact with upper portions of the plurality of gate electrodes, and
in a horizontal direction, widths of the plurality of vertical plug portions are greater than widths of the plurality of protrusion plug portions.

15. The vertical non-volatile memory device of claim 13 or claim 14, further comprising:
a through structure on one side of the extension structure, wherein
the through structure includes a dummy stack,
the dummy stack includes a plurality of dummy gate electrodes and a plurality of insulating layers alternately stacked.
